# EUROPEAN PATENT APPLICATION

(11) **EP 4 606 914 A1**
(43) Date of publication of application: **27.08.2025**
(21) Application number: 23894572.9
(22) Date of filing: 21.11.2023
(51) Int. Cl.: C21D 8/12, C21D 9/46, H01F 1/147, H01F 41/02, C22C 38/00, C22C 38/60

(54) **MODEL FOR PREDICTING OXYGEN AMOUNT PER UNIT AREA AFTER DECARBURIZATION ANNEALING, METHOD FOR PRODUCING SAME, AND METHOD FOR MANUFACTURING GRAIN-ORIENTED ELECTRICAL STEEL SHEET**

(30) Priority: 22.11.2022 JP 2022186536
(71) Applicant: JFE Steel Corporation, Tokyo 100-0011 (JP)
(72) Inventor: YAMADA, Takuya, Tokyo 100-0011 (JP); WATANABE, Makoto, Tokyo 100-0011 (JP); TERASHIMA, Takashi, Tokyo 100-0011 (JP)
(74) Representative: Grünecker Patent- und Rechtsanwälte PartG mbB
(86) International application number: PCT/JP2023/041720
(87) International publication number: WO 2024/111567

(57) **Abstract**

This model predicts an oxygen coating weight after decarburization annealing, and is used when producing a grain-oriented electrical steel sheet by subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing. This model is created with at least three of steel material components, annealing conditions before final cold rolling, and decarburization annealing conditions set as explanatory variables, and a target variable corresponding to these explanatory variables set as the oxygen coating weight after decarburization annealing. A grain-oriented electrical steel sheet is manufactured with decarburization annealing conditions set using the prediction model of an oxygen coating weight thus created such that the oxygen coating weight after decarburization annealing meets a target value.

## Description

### Technical Field

The present invention relates to a model that predicts an oxygen coating weight on a steel sheet surface after decarburization annealing that has a major influence on the coating properties and the magnetic properties of a grain-oriented electrical steel sheet, a method for creating this model, and a method for producing a grain-oriented electrical steel sheet that uses this prediction model.

### Background Art

Grain-oriented electrical steel sheets are a soft magnetic material used mainly for iron cores of transformers etc., and are strongly required to have excellent magnetic properties, particularly, to have small iron loss and high magnetic flux density. Such grain-oriented electrical steel sheets are commonly produced by subjecting a steel material containing a component that forms an inhibitor, such as MnS, MnSe, and AlN, to hot rolling, hot strip annealing as necessary, and cold rolling once, or cold rolling twice or more with intermediate annealing in between, into a cold-rolled sheet with a final sheet thickness, subjecting this cold-rolled sheet to decarburization annealing, and then performing finishing annealing that causes secondary recrystallization. In recent years, production technologies of grain-oriented electrical steel sheets that cause secondary recrystallization without using an inhibitor have also been developed and put into practice.

In the finishing annealing, the steel sheet is annealed in a state of having been wound in a coil shape. Therefore, for the purpose of preventing the steel sheet from sticking to itself, it is common practice to apply an annealing separating agent containing MgO as a main agent to the steel sheet surface having been subjected to decarburization annealing. The MgO plays not only a role as the aforementioned annealing separating agent but also a role in forming a forsterite coating by reacting with an oxidized film composed mainly of SiO₂ that is formed on the steel sheet surface during decarburization annealing. This forsterite coating imparts insulation properties to the steel sheet surface as well as imparts tensile stress to the steel sheet surface by taking advantage of the low thermal expansion coefficient of the coating, thereby contributing to reducing the iron loss.

The above-described forsterite coating is formed as follows. First, a cold-rolled sheet having been reduced to a final sheet thickness by cold rolling is subjected to decarburization annealing. As a result of this decarburization annealing, C in the steel sheet is reduced to 0.003 mass% or less at which magnetic aging of the product sheet can be prevented, and at the same time, an oxidized film composed mainly of SiO₂ is formed on the steel sheet surface. Thereafter, an annealing separating agent containing MgO as a main agent is applied to the steel sheet surface, and then finishing annealing is performed at a high temperature. In the process, a forsterite coating is formed according to the following reaction formula:

SiO₂ + 2MgO → Mg₂SiO₄

Thus, the forsterite coating is formed by, as one of its materials, the oxidized film that is composed mainly of SiO₂ and formed on the steel sheet surface during decarburization annealing. Therefore, forming a forsterite coating with excellent coating properties requires controlling the amount of this oxidized film within an appropriate range. The amount of oxidized film is in an approximately proportional relationship with the amount of oxygen on the steel sheet surface, and is therefore hereinafter substituted by "oxygen coating weight".

Incidentally, the formation behavior of the forsterite coating has a profound influence on the formation of an inhibitor, such as MnS, MnSe, or AlN, as well. The forsterite coating is known to contribute to improving the magnetic properties also by taking in the inhibitor that has become unnecessary upon completion of secondary recrystallization and purifying the steel sheet itself. Therefore, forming a forsterite coating with excellent coating properties, i.e., with excellent uniformity and adhesiveness is extremely important in producing a grain-oriented electrical steel sheet with excellent magnetic properties.

As for methods of producing a grain-oriented electrical steel sheet with excellent coating properties, many technologies have been disclosed. For example, Patent Literature 1 discloses a technology for producing a grain-oriented electrical steel sheet with excellent magnetic properties by containing Cr and one or both of Sb and Cu in the steel material so as to meet a predetermined relationship and forming an oxidized film with excellent adhesiveness on the steel sheet surface. Patent Literature 2 discloses a technology for producing a grain-oriented electrical steel sheet with uniform surface properties throughout an entire coil while reducing the iron loss by controlling the depth of a desiliconized layer before final cold rolling within a predetermined range.

### Citation List

### Patent Literature

Patent Literature 1: JP-A-2003-193134
Patent Literature 2: JP-A-H11-152517

### Summary of Invention

### Technical Problem

Applying the above-described conventional technologies can achieve an improving effect on coating properties to some extent. However, according to studies by the present inventors, even when these technologies were applied, degradation of the coating properties and degradation of the magnetic properties due to variations in the oxygen coating weight on the steel sheet surface after decarburization annealing were still observed.

Having been developed in view of the above problem faced by the conventional technologies, the present invention aims to provide a model that predicts an oxygen coating weight on a steel sheet surface after decarburization annealing for stably producing a grain-oriented electrical steel sheet with excellent coating properties and, consequently, excellent magnetic properties, and propose a method for creating thereof and a method for producing a grain-oriented electrical steel sheet that uses this model.

### Solution to Problem

Aiming at solving the above problem, the present inventors vigorously conducted studies with a focus on a cause for variations in an oxygen coating weight on a steel sheet surface after decarburization annealing. The oxygen coating weight varies depending not only on decarburization annealing conditions but also on various factors such as the components of the steel material and the production conditions before the decarburization annealing step. In the above-described related art, the oxygen coating weight was controlled by specifying one production condition among these conditions. However, it is considered essentially necessary to control the oxygen coating weight by specifying all the aforementioned production conditions. In the present invention, therefore, creating a prediction model of an oxygen coating weight was considered for which these production conditions were set as explanatory variables and an oxygen coating weight corresponding to these production conditions was set as a target variable. As a result, it was found that, to create a high-accuracy prediction model of an oxygen coating weight, it was important to use, as the explanatory variables, at least three of steel material components, annealing conditions before final cold rolling, and decarburization annealing conditions, and that setting the decarburization annealing conditions using this prediction model of an oxygen coating weight made it possible to significantly reduce the variations in the oxygen coating weight and to thereby stably produce a grain-oriented electrical steel sheet with excellent coating properties and magnetic properties. Thus, the present invention was completed.

Specifically, the present invention is a prediction model of an oxygen coating weight after decarburization annealing that is used when producing a grain-oriented electrical steel sheet by subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential). This prediction model of an oxygen coating weight is characterized in that at least three of steel material components, annealing conditions before final cold rolling, and decarburization annealing conditions are set as explanatory variables, and that a target variable corresponding to these explanatory variables is set as the oxygen coating weight after decarburization annealing. Here, the final cold rolling refers to cold rolling of rolling to a final sheet thickness, and the annealing before the final cold rolling refers to hot strip annealing when annealing performed in a step before the final cold rolling is only hot strip annealing, and to intermediate annealing when the annealing is only intermediate annealing or both of hot strip annealing and intermediate annealing.

The prediction model of an oxygen coating weight for a grain-oriented electrical steel sheet of the present invention is characterized in that the explanatory variables to be used are as follows: as the steel material components, concentrations of at least C, Si, Mn, and Sb; as the annealing conditions before the final cold rolling, at least a soaking temperature, a soaking time, and an oxygen potential P_{H2O}/P_{H2} of an atmospheric gas during soaking; and as the decarburization annealing conditions, at least a decarburization temperature, a decarburization time, and an oxygen potential P_{H2O}/P_{H2} of an atmospheric gas during decarburization.

The present invention proposes a method for creating a prediction model of an oxygen coating weight after decarburization annealing that is used when producing a grain-oriented electrical steel sheet by subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential). This method is characterized in that the model that predicts the oxygen coating weight is created with at least three of steel material components, annealing conditions before final cold rolling, and decarburization annealing conditions set as explanatory variables, and a target variable corresponding to these explanatory variables set as the oxygen coating weight after decarburization annealing. Here, the final cold rolling refers to cold rolling of rolling to a final sheet thickness, and the annealing before the final cold rolling refers to hot strip annealing when annealing performed in a step before the final cold rolling is only hot strip annealing, and to intermediate annealing when the annealing is only intermediate annealing or both of hot strip annealing and intermediate annealing.

The method for creating a prediction model of an oxygen coating weight for a grain-oriented electrical steel sheet of the present invention is characterized in that the explanatory variables to be used are as follows: as the steel material components, concentrations of at least C, Si, Mn, and Sb; as the annealing conditions before the final cold rolling, at least a soaking temperature, a soaking time, and an oxygen potential P_{H2O}/P_{H2} of an atmospheric gas during soaking; and as the decarburization annealing conditions, at least a decarburization temperature, a decarburization time, and an oxygen potential P_{H2O}/P_{H2} of an atmospheric gas during decarburization.

The method for creating a prediction model of an oxygen coating weight for a grain-oriented electrical steel sheet of the present invention is characterized in that the creation of a prediction model of an oxygen coating weight is performed by multiple regression analysis or machine learning.

The present invention proposes a method for producing a grain-oriented electrical steel sheet including a series of steps of subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential). This production method is characterized in that, using the prediction model of an oxygen coating weight described above, decarburization annealing conditions are set based on at least steel material components and annealing conditions before final cold rolling such that an oxygen coating weight after decarburization annealing meets a target value.

### Advantageous Effects of Invention

According to the present invention, the oxygen coating weight on the steel sheet surface after decarburization annealing can be controlled within an appropriate range and, moreover, the variations therein can be significantly reduced, which makes it possible to stably produce a grain-oriented electrical steel sheet with excellent coating properties and, consequently, excellent magnetic properties.

### Description of Embodiment

First, the basic technical idea of the present invention will be described.

As described above, the amount of oxidized film, i.e., the oxygen coating weight on a steel sheet surface after decarburization annealing is considered to vary depending not only on the decarburization annealing conditions but also on various conditions such as the component composition of the steel material that is the starting material and the production conditions before the decarburization annealing step. For example, as for the influence of the decarburization annealing conditions, when the decarburization annealing temperature (decarburization temperature) is high, diffusion of oxygen is promoted, so that the oxygen coating weight becomes large. The same is true in the case where the decarburization annealing time (decarburization time) is long or the case where the oxygen potential (P_{H2O}/P_{H2}) of the atmospheric gas during decarburization is high.

As for the influence of the component composition of the steel material, when the C concentration is high, the amount of oxygen consumed by decarburization becomes large, so that the oxygen coating weight becomes small. Conversely, when the Si concentration is high, the amount of Si diffused to the steel sheet surface becomes large and an Si oxide increases, so that the oxygen coating weight becomes large. Also when the Mn concentration is high, as the formation of a high-order oxide, such as (Fe, Mn)₂SiO₄, is promoted, the oxygen coating weight becomes large. On the other hand, when the Sb concentration is high, as diffusion of oxygen is restricted by surface segregation of Sb, the oxygen coating weight becomes small.

In an annealing step that is performed before cold rolling, a desiliconized layer is formed on the steel sheet surface layer. The desiliconized layer has an effect of restricting initial oxidation during decarburization annealing and preventing an excessive increase in the oxygen coating weight. Further, when the annealing temperature is high, this desiliconized layer becomes thick and therefore the oxygen coating weight becomes small. The same is true in the case where the annealing time is long or the case where the oxygen potential (P_{H2O}/P_{H2}) of the atmospheric gas is high. In particular, this tendency is noticeable in annealing near final cold rolling (cold rolling to a final sheet thickness).

As has been described above, numerous production conditions influence the amount of oxidized film formed (oxygen coating weight) on the steel sheet surface during decarburization annealing. Nevertheless, as described above, the conventional technologies control the oxygen coating weight by specifying one production condition among these production conditions. However, it is considered that, essentially, the oxygen coating weight should be controlled with all production conditions taken into account.

In the present invention, therefore, with these numerous production conditions set as explanatory variables and an oxygen coating weight corresponding to these production conditions set as a target variable, a model that predicts an oxygen coating weight was created by multiple regression analysis or machine learning, and the prediction accuracy of the oxygen coating weight after decarburization annealing was examined. As a result, it was learned that a high-accuracy prediction model of an oxygen coating weight could be obtained by using, as the explanatory variables, at least three of the steel material components, the annealing conditions before final cold rolling, and the decarburization annealing conditions among the numerous production conditions. Then, it was found that setting the decarburization annealing conditions using this prediction model and based on at least the steel material components and the annealing conditions before final cold rolling could control the oxygen coating weight on the steel sheet surface after decarburization annealing within a predetermined range as well as significantly reduce the variations, making it possible to stably produce a grain-oriented electrical steel sheet with excellent coating properties and magnetic properties. Thus, the present invention was completed.

Next, a preferred component composition of the steel material used for producing the grain-oriented electrical steel sheet of the present invention will be described.

### C: 0.01 to 0.1 mass%

C is an important component for improving the texture of the steel sheet, but when the content is less than 0.01 mass%, this improving effect is not sufficiently obtained. On the other hand, when the content of C exceeds 0.1 mass%, it becomes difficult to reduce the content of C to 0.003 mass% or less at which magnetic aging does not occur during decarburization annealing. Therefore, the content of C should be in the range of 0.01 to 0.1 mass%. Preferably, it should be in the range of 0.02 to 0.08 mass%.

### Si: 2.0 to 5.0 mass%

Si is an effective component for enhancing the specific resistance of the steel and reducing the eddy current loss. However, when the content of Si is less than 2.0 mass%, this effect is not sufficiently obtained. On the other hand, when the content of Si exceeds 5.0 mass%, cold rollability degrades significantly. Therefore, the content of Si should be in the range of 2.0 to 5.0 mass%. Preferably, it should be in the range of 2.5 to 4.5 mass%.

### Mn: 0.01 to 1.0 mass%

In addition to having an effect of enhancing the specific resistance of the steel and reducing the eddy current loss as with Si, Mn has an effect of improving hot rollability. However, when the content of Mn is less than 0.01 mass%, this effect is not sufficiently obtained. On the other hand, when the content of Mn exceeds 1.0 mass%, γ transformation is induced after secondary recrystallization, which adversely influences the magnetic properties. Therefore, Mn should be contained in the range of 0.01 to 1.0 mass%. Preferably, Mn should be contained in the range of 0.01 to 0.5 mass%.

Components other than C, Si, and Mn described above differ between a case where an inhibitor, such as AlN, MnS, or MnSe, is used to cause secondary recrystallization and a case where an inhibitor is not used.

When AlN is used as an inhibitor in the case where an inhibitor is used to cause secondary recrystallization, it is preferable that Al: 0.010 to 0.04 mass% and N: 0.005 to 0.01 mass% be contained. On the other hand, when using MnS and/or MnSe as an inhibitor, it is preferable that S: 0.005 to 0.03 mass% and/or Se: 0.005 to 0.03 mass% be further contained in addition to the aforementioned Mn. The aforementioned inhibitors may be used independently or in combination.

On the other hand, in the case where an inhibitor is not used to cause secondary recrystallization, it is preferable that Al, N, S, and Se, which are inhibitor-forming components, be reduced as much as possible. Specifically, it is preferable that Al: less than 0.010 mass%; N: less than 0.005 mass%; S: less than 0.005 mass%; and Se: less than 0.005 mass%.

For the purpose of improving the magnetic properties, the steel material used for the present invention may contain, other than the above-described components, one or more selected from the group consisting of B: 0.0001 to 0.005 mass%, Ti: 0.001 to 0.01 mass%, P: 0.005 to 0.1 mass%, Cr: 0.01 to 0.5 mass%, Ni: 0.01 to 1.5 mass%, Cu: 0.01 to 0.5 mass%, Nb: 0.002 to 0.08 mass%, Mo: 0.005 to 0.1 mass%, Sn: 0.005 to 0.5 mass%, Sb: 0.005 to 0.5 mass%, and Bi: 0.001 to 0.05 mass%.

The steel material used for the present invention has, other than the above-described components, a balance substantially consisting of Fe and unavoidable impurities.

As described above, the contents of C, Si, and Mn, which are essential components among the steel material components described above, have a major influence on the oxygen coating weight on the steel sheet surface after decarburization annealing, and are therefore essential as explanatory variables used to create the prediction model. Among the optional additive elements described above, particularly Sb is an element that has a major influence on the oxygen coating weight after decarburization annealing by segregating on the steel sheet surface and restricting diffusion of oxygen during annealing. Therefore, while Sb is an optional additive element, also when Sb is not intentionally added (when Sb is contained as an unavoidable impurity), Sb needs to be an essential explanatory variable used to create the prediction model of an oxygen coating weight after decarburization annealing.

Next, a method for producing the grain-oriented electrical steel sheet of the present invention will be described.

First, a steel material having a component composition complying with the present invention described above is hot-rolled into a hot-rolled sheet, and this hot-rolled sheet is subjected to hot strip annealing as necessary. Here, the preferable conditions of the hot strip annealing are such that the soaking temperature is in the range from 800 to 1150°C and the soaking time is in the range from 20 to 120s. When the soaking temperature of hot strip annealing is lower than 800°C and/or the soaking time thereof is less than 20s, a band structure formed during hot rolling remains and a uniformly grained primary recrystallization structure cannot be obtained, which may hinder the grain growth during secondary recrystallization. On the other hand, when the soaking temperature of hot strip annealing exceeds 1150°C and/or the soaking time thereof exceeds 120s, the grain diameter after hot strip annealing becomes so large that, again, it becomes difficult to obtain a uniformly grained primary recrystallization structure.

From the viewpoint of forming a decarburized layer on the steel sheet surface layer after hot strip annealing and thereby promoting secondary recrystallization in sharp Goss orientation during finishing annealing and improving the magnetic properties, it is preferable that the atmosphere during soaking in the hot strip annealing be an oxidizing atmosphere composed mainly of an inert gas, and that the oxygen potential P_{H2O}/P_{H2} of the atmospheric gas be within a range of 0.1 to 1.0. When P_{H2O}/P_{H2} is less than 0.1, the formation of the decarburized layer is not promoted and the magnetic properties of the product degrade. On the other hand, when P_{H2O}/P_{H2} exceeds 1.0, a large amount of oxide is formed on the steel sheet surface layer, so that descaling becomes difficult and the rolling load in the subsequent cold rolling increases, leading to reduced productivity.

Next, the hot-rolled sheet after the hot rolling or hot strip annealing is descaled by pickling etc. and is then cold-rolled once or cold-rolled twice or more with intermediate annealing in between, into a cold-rolled sheet with a final sheet thickness (product sheet thickness). When performing the intermediate annealing, the preferable conditions are such that the soaking temperature is in the range from 900 to 1200°C and the soaking time is in the range from 20 to 120s. When the soaking temperature of intermediate annealing is lower than 900°C and/or the soaking time thereof is less than 20s, the grain diameter after intermediate annealing becomes so small that Goss nuclei in the primary recrystallization structure decrease, which may degrade the magnetic properties. On the other hand, when the soaking temperature exceeds 1200°C and/or the soaking time exceeds 120s, the grain diameter after intermediate annealing becomes so large that, again, it becomes difficult to obtain a uniformly grained primary recrystallization structure.

From the viewpoint of controlling the desiliconized layer and the oxide layer formed on the steel sheet surface layer after intermediate annealing, it is preferable that the atmosphere during soaking in the intermediate annealing be an oxidizing atmosphere containing an inert gas, such as nitrogen, and hydrogen, and that the oxygen potential P_{H2O}/P_{H2} of that atmospheric gas be within the range of 0.01 to 1.0. When P_{H2O}/P_{H2} is less than 0.01, the desiliconized layer is not formed on the steel sheet surface after intermediate annealing or the desiliconized layer becomes so thin that formation failure of a forsterite coating during finishing annealing occurs. On the other hand, when P_{H2O}/P_{H2} exceeds 1.0, a large amount of oxide is formed on the steel sheet surface after intermediate annealing, so that it becomes difficult to remove the oxide by pickling etc., and the rolling load in the subsequent cold rolling increases or the surface properties of the steel sheet degrade, resulting in reduced productivity.

In the method for producing the grain-oriented electrical steel sheet of the present invention, it is essential that at least one annealing of the hot strip annealing and the intermediate annealing described above is performed.

Next, the cold-rolled sheet reduced to the final sheet thickness is subjected to decarburization annealing that serves also as primary recrystallization annealing. It is preferable that the decarburization temperature of the decarburization annealing be within the range of 750 to 950°C and that the decarburization time thereof be within the range of 80 to 200s. When the decarburization temperature is lower than 750°C and/or the decarburization time is less than 80s, decarburization becomes insufficient, or the grain diameter of the primary recrystallization grains becomes so small that the driving force of secondary recrystallization becomes excessive, which may result in a lower degree of integration in Goss orientation after secondary recrystallization. On the other hand, when the decarburization temperature exceeds 950°C and/or the decarburization time exceeds 200s, the grain diameter of primary recrystallization grains becomes so large that secondary recrystallization may be conversely restricted.

From the viewpoint of promoting the decarburization reaction or forming a favorable internal oxidized layer, it is preferable that the atmosphere during decarburization in the decarburization annealing be a wet hydrogen atmosphere of hydrogen alone or a mixed gas of an inert gas, such as nitrogen or argon, and hydrogen, etc., and that the oxygen potential P_{H2O}/P_{H2} of that atmospheric gas be within the range of 0.1 to 0.8. When P_{H2O}/P_{H2} is less than 0.1, decarburization becomes insufficient and degradation of the magnetic properties of the product due to magnetic aging may occur. On the other hand, when P_{H2O}/P_{H2} exceeds 0.8, the oxygen coating weight on the steel sheet surface after decarburization annealing becomes excessive and the forsterite coating formed during finishing annealing becomes so thick that a defect, such as point-like stripping, may occur.

It is preferable that the decarburization annealing conditions be controlled such that the oxygen coating weight (per both sides) of the steel sheet surface after decarburization annealing falls within a range of 0.70 to 1.50 g/m². When the oxygen coating weight is less than 0.70 g/m², the thickness of the forsterite coating formed during finishing annealing becomes so thin that it may become prone to breaking under external stress and the coating adhesiveness may degrade. On the other hand, when the oxygen coating weight exceeds 1.50 g/m², the thickness of the forsterite coating becomes so thick that a defect, such as point-like stripping, may occur. The oxygen coating weight is more preferably within a range of 0.75 to 1.35 g/m². Here, the oxygen coating weight is a value obtained by measuring the oxygen content in the steel sheet after decarburization annealing along its entire thickness in accordance with JIS G 1239: 2014 (Iron and steel - Determination of oxygen - Infrared absorption method after fusion under inert gas) and converting the obtained total oxygen amount into an oxygen amount per unit surface area (both sides) of the steel sheet.

Here, what is important in the present invention is to create the prediction model of an oxygen coating weight using historical data of production conditions from the past few years, and to set the decarburization annealing conditions using that prediction model of an oxygen coating weight and based on at least the above-described steel material components and the annealing conditions before the final cold rolling such that the oxygen coating weight on the steel sheet surface after decarburization annealing that is the control target falls within a predetermined range. Here, the final cold rolling refers to cold rolling of rolling to the final sheet thickness. The annealing conditions before the final cold rolling refer to the conditions of hot strip annealing when annealing performed in a step before the final cold rolling is only hot strip annealing, and to the conditions of intermediate annealing when the annealing is only intermediate annealing or when both of hot strip annealing and intermediate annealing are performed.

It is preferable that the prediction model of an oxygen coating weight be created by multiple regression analysis or machine learning, with at least three of the above-described steel material components plus the annealing conditions before final cold rolling and the decarburization annealing conditions among the pieces of historical data of production conditions from the past few years set as explanatory variables, and an oxygen coating weight corresponding to these production conditions set as a target variable. However, other methods than the aforementioned ones may be used.

Here, it is important that the explanatory variables in the annealing conditions before final cold rolling and the decarburization annealing conditions used to create the prediction model of an oxygen coating weight be ones that have a major influence on the oxygen coating weight on the steel sheet surface after decarburization annealing. Specifically, for the annealing conditions before the final cold rolling, at least the soaking temperature, the soaking time, and the oxygen potential P_{H2O}/P_{H2} of the atmosphere during soaking, and for the decarburization annealing conditions, at least the decarburization temperature, the decarburization time, and the oxygen potential P_{H2O}/P_{H2} of the atmospheric gas during decarburization need to be used as the explanatory variables of the prediction model of an oxygen coating weight. It goes without saying that production conditions other than those described above may be added to the explanatory variables for the purpose of further improving the accuracy of the prediction model of an oxygen coating weight.

While an algorithm of machine learning used to create the prediction model of an oxygen coating weight is not particularly limited, for example, random forest may be used or neural network may be used.

Next, an annealing separating agent containing MgO as a main agent is applied to the steel sheet surface after the decarburization annealing and dried, and then finishing annealing is performed to cause secondary recrystallization and form a forsterite coating. "Containing MgO as a main agent" means that the content of MgO in the entire annealing separating agent exceeds 50 mass%.

Thereafter, an unreacted portion of the annealing separating agent is removed from the finishing-annealed steel sheet by pickling etc., and then, as necessary, flattening annealing serving also as shape correction of the steel sheet is performed, or an insulation coating is formed, or a magnetic domain subdividing treatment is performed to obtain a product sheet.

### Example 1

With historical data of production conditions of grain-oriented electrical steel sheets from the past two years set as explanatory variables and an oxygen coating weight of a steel sheet after decarburization annealing set as a target variable, a prediction model of an oxygen coating weight of a steel sheet after decarburization annealing was created using random forest that is one of machine learning tools. In this case, for the explanatory variables used to create the prediction model, the following four standards were adopted: using only historical data of the decarburization annealing conditions from the past two years (Standard 1); using historical data of the two of the steel material components and the decarburization annealing conditions from the past two years (Standard 2); using historical data of the two of the annealing conditions before final cold rolling and the decarburization annealing conditions from the past two years (Standard 3); and using historical data of the three of the steel material components, the annealing conditions before final cold rolling, and the decarburization annealing conditions from the past two years (Standard 4).

Next, steel materials (slabs) having the four types of component compositions illustrated in Table 1 were subjected to hot rolling, hot strip annealing under the conditions (the soaking temperature, the soaking time, and P_{H2O}/P_{H2} of the atmospheric gas during soaking) illustrated in Table 1, and cold rolling once (without intermediate annealing) to obtain cold-rolled sheets with a final sheet thickness of 0.23 mm. Thereafter, decarburization annealing that served also as primary recrystallization annealing was performed under the conditions (the decarburization temperature, the decarburization time, and P_{H2O}/P_{H2} of the atmospheric gas during decarburization) illustrated in Table 1. Then, the oxygen coating weights on the steel sheet surfaces after the decarburization annealing were measured in accordance with JIS G 1239: 2014 and compared with oxygen coating weights that were predicted by the prediction models created using the explanatory variables of Standards 1 to 4 described above.

The result is included in Table 1. This result demonstrates that the prediction model of an oxygen coating weight (Standard 4) of the present invention that was created using the historical data of at least three of the steel material components, the annealing conditions before final cold rolling, and the decarburization annealing conditions could accurately predict the oxygen coating weight after decarburization annealing, with the deviations of the measured values of the oxygen coating weights from the predicted values thereof being within ±3%.

**[Table 1]**

| 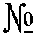 | Material component (mass%) | | | | Hot strip annealing | | | Decarburization annealing | | | Oxygen coating weight (g/m²) | | Explanatory variable | Remarks |
|---|---|---|---|---|---|---|---|---|---|---|---|---|---|---|
| | C | Si | Mn | Sb | Temp. (°C) | Time (s) | P_{H2O} /P_{H2} | Temp. (°C) | Time (s) | P_{H2O} /P_{H2} | Measured value | Predicted value | | |
| 1 | 0.078 | 3.28 | 0.162 | 0.148 | 1031 | 62 | 0.49 | 911 | 91 | 0.30 | 0.97 | 0.83 | Decarburization annealing condition | Comparative Example |
| 2 | | | | | | | | | | | | 0.85 | Material component+ Decarburization annealing condition | Comparative Example |
| 3 | | | | | | | | | | | | 0.93 | Hot strip annealing condition + Decarburization annealing condition | Comparative Example |
| 4 | | | | | | | | | | | | 0.95 | Material component + Hot strip annealing condition+ Decarburization annealing condition | Invention Example |
| 5 | 0.052 | 4.67 | 0.141 | 0.185 | 951 | 76 | 0.4 | 837 | 153 | 0.42 | 1.35 | 1.03 | Decarburization annealing condition | Comparative Example |
| 6 | | | | | | | | | | | | 1.24 | Material component + Decarburization annealing condition | Comparative Example |
| 7 | | | | | | | | | | | | 1.16 | Hot strip annealing condition + Decarburization annealing condition | Comparative Example |
| 8 | | | | | | | | | | | | 1.35 | Material component + Hot strip annealing condition+ Decarburization annealing condition | Invention Example |
| 9 | 0.066 | 4.38 | 0.141 | 0.119 | 1030 | 78 | 0.48 | 776 | 116 | 0.43 | 1.23 | 0.95 | Decarburization annealing condition | Comparative Example |
| 10 | | | | | | | | | | | | 1.16 | Material component + Decarburization annealing condition | Comparative Example |
| 11 | | | | | | | | | | | | 1.04 | Hot strip annealing condition + Decarburization annealing condition | Comparative Example |
| 12 | | | | | | | | | | | | 1.26 | Material component + Hot strip annealing condition + Decarburization annealing condition | Invention Example |
| 13 | 0.046 | 3.41 | 0.146 | - | 1047 | 54 | 0.84 | 836 | 127 | 0.45 | 1.01 | 0.89 | Decarburization annealing condition | Comparative Example |
| 14 | | | | | | | | | | | | 0.96 | Material component + Decarburization annealing condition | Comparative Example |
| 15 | | | | | | | | | | | | 0.95 | Hot strip annealing condition + Decarburization annealing condition | Comparative Example |
| 16 | | | | | | | | | | | | 1.02 | Material component + Hot strip annealing condition + Decarburization annealing condition | Invention Example |

### Example 2

With historical data of the steel material components, the annealing conditions before final cold rolling, and the decarburization annealing conditions from the past two years set as explanatory variables and an oxygen coating weight after decarburization annealing set as a target variable, a prediction model of an oxygen coating weight was created using neural network, which is one of machine learning tools.

Next, steel materials (slabs) having the various types of component compositions illustrated in Table 2 were subjected to hot rolling and then to hot strip annealing at a soaking temperature of 1000°C for a soaking time of 60s in an atmosphere of P_{H2O}/P_{H2}: 0.30. Then, the hot-rolled sheets were cold-rolled for the first time to an intermediate sheet thickness, subjected to intermediate annealing under the conditions (the soaking temperature, the soaking time, P_{H2O}/P_{H2} of the atmospheric gas during soaking) illustrated in Table 2, and then cold-rolled for the second time into cold-rolled sheets with a final sheet thickness of 0.23 mm. Next, decarburization annealing that served also as primary recrystallization annealing was performed on these cold-rolled sheets. In this case, as illustrated in Table 2, the conditions of the decarburization annealing were the following two conditions: a case where the decarburization temperature and the decarburization time were uniformly set to 840°C and 120s, respectively, and the oxygen potential P_{H2O}/P_{H2} of the atmospheric gas during decarburization was uniformly set to 0.50 (Comparative Example); and a case where the decarburization temperature and the decarburization time were uniformly set to 840°C and 120s, respectively, and the oxygen potential P_{H2O}/P_{H2} of the atmospheric gas during decarburization was set using the prediction model of an oxygen coating weight created as described above such that the oxygen coating weight became 0.90 g/m² (Invention Example). Thereafter, the oxygen coating weights of the steel sheets after the decarburization annealing were measured in accordance with JIS G 1239: 2014.

Next, an annealing separating agent in which TiO₂: 2.0 parts by mass were added to MgO: 100 parts by mass was turned into slurry and applied to the steel sheet surfaces after decarburization annealing and dried. Then, finishing annealing in which secondary recrystallization was completed under the conditions of 850°C for 50 hr followed by purification under the conditions of 1200°C for 5 hr, was performed. Next, an unreacted portion of the annealing separating agent was removed from the finishing-annealed steel sheets, and then an insulation coating composed mainly of phosphate was applied, and flattening annealing that served as both baking and shape correction of the coating was performed under the conditions of 850°C for 1 min to obtain product sheets.

Next, test samples were taken from the product sheets to evaluate the coating properties (uniformity, adhesiveness) and the magnetic properties (magnetic flux density B₈, iron loss W_{17/50}). Specifically, for the uniformity of the coating, the appearance of the coating was visually observed and evaluated as good when it was uniform, fair when it was rather non-uniform, and poor when it was non-uniform. For the adhesiveness of the coating, each product sheet was wound around round rods of various diameters and the adhesiveness was evaluated based on the smallest diameter at which the coating did not strip ("bending stripping diameter"). The magnetic flux density B₈ and the iron loss W_{17/50} were measured in accordance with JIS C 2556: 2015.

The measurement result is included in Table 2. From this result, in the cases where the prediction model of an oxygen coating weight of the present invention was applied, the variations in the oxygen coating weight were significantly reduced. As a result, the variations in the coating properties and the magnetic properties were also considerably reduced, and in all the steel sheets, a difference between the maximum value and the minimum value of the magnetic flux density of ΔB₈ = 0.005T and a difference between the maximum value and the minimum value of iron loss of ΔW_{17/50} = 0.062 W/kg were achieved. On the other hand, among the cases where the prediction model of an oxygen coating weight of the present invention was not applied, in the steel sheets No. 6 and 10 for which the oxygen potential P_{H2O}/P_{H2} obtained by the prediction model happened to be near the set value 0.50 of Comparative Examples, favorable coating properties and magnetic properties were obtained. However, taken as a whole, the variations in the coating properties and the magnetic properties are large (ΔB₈ = 0.173T, ΔW_{17/50} = 0.383 W/kg), which demonstrates that steel sheets having excellent coating properties and magnetic properties failed to be stably obtained.

**[Table 2]**

| 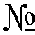 | Material component (mass%) | | | | Intermediate annealing | | | Decarburization annealing | | | Prediction model of present invention applied or not applied | Measured value of oxygen coating weight (g/m²) | Coating properties | | Magnetic properties | | Remarks |
|---|---|---|---|---|---|---|---|---|---|---|---|---|---|---|---|---|---|
| | C | Si | Mn | Sb | Temp. (°C) | Time (s) | P_{H2O}/ P_{H2} | Temp. (°C) | Time (s) | P_{H2O}/ P_{H2} | | | Coating appearance * | Bending and stripping diameter (mm) | Magnetic flux density B₈(T) | Iron loss W_{17/50} (W/kg) | |
| 1 | 0.033 | 3.95 | 0.047 | 0.059 | 1025 | 70 | 0.44 | 840 | 120 | 0.42 | Applied | 0.91 | Good | 20 | 1.947 | 0.745 | Invention Example |
| 2 | | | | | | | | 840 | 120 | 0.50 | Not applied | 1.04 | Fair | 30 | 1.919 | 0.801 | Comparative Example |
| 3 | 0.044 | 4.52 | 0.230 | 0.196 | 977 | 67 | 0.45 | 840 | 120 | 0.39 | Applied | 0.89 | Good | 20 | 1.945 | 0.711 | Invention Example |
| 4 | | | | | | | | 840 | 120 | 0.50 | Not applied | 1.14 | Poor | 40 | 1.895 | 0.811 | Comparative Example |
| 5 | 0.024 | 3.15 | 0.276 | 0.496 | 1031 | 60 | 0.40 | 840 | 120 | 0.48 | Applied | 0.91 | Good | 20 | 1.949 | 0.769 | Invention Example |
| 6 | | | | | | | | 840 | 120 | 0.50 | Not applied | 0.93 | Good | 20 | 1.941 | 0.785 | Comparative Example |
| 7 | 0.047 | 3.65 | 0.312 | 0.402 | 931 | 67 | 0.33 | 840 | 120 | 0.57 | Applied | 0.93 | Good | 20 | 1.950 | 0.740 | Invention Example |
| 8 | | | | | | | | 840 | 120 | 0.50 | Not applied | 0.62 | Poor | 40 | 1.768 | 1.104 | Comparative Example |
| 9 | 0.050 | 4.71 | 0.047 | 0.427 | 1061 | 78 | 0.34 | 840 | 120 | 0.51 | Applied | 0.89 | Good | 20 | 1.947 | 0.707 | Invention Example |
| 10 | | | | | | | | 840 | 120 | 0.50 | Not applied | 0.88 | Good | 20 | 1.940 | 0.721 | Comparative Example |
| 11 | 0.071 | 3.21 | 0.325 | - | 970 | 80 | 0.40 | 840 | 120 | 0.43 | Applied | 0.91 | Good | 20 | 1.949 | 0.767 | Invention Example |
| 12 | | | | | | | | 840 | 120 | 0.50 | Not applied | 1.04 | Fair | 30 | 1.913 | 0.836 | Comparative Example |

| | | | | | | | | | | | | | | | | | |
|---|---|---|---|---|---|---|---|---|---|---|---|---|---|---|---|---|---|
| * Evaluation of coating appearance: "Good" means uniform, "Fair" means rather non-uniform, and "Poor" means non-uniform | | | | | | | | | | | | | | | | | |

## Claims

1. A prediction model of an oxygen coating weight after decarburization annealing that is used when producing a grain-oriented electrical steel sheet by subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential),
**characterized in that**
at least three of steel material components, annealing conditions before final cold rolling, and decarburization annealing conditions are set as explanatory variables, and that a target variable corresponding to these explanatory variables is set as the oxygen coating weight after decarburization annealing, wherein
the final cold rolling refers to cold rolling of rolling to a final sheet thickness, and the annealing before the final cold rolling refers to hot strip annealing when annealing performed in a step before the final cold rolling is only hot strip annealing, and to intermediate annealing when the annealing is only intermediate annealing or both of hot strip annealing and intermediate annealing.

2. The prediction model of an oxygen coating weight according to claim 1, wherein
the explanatory variables to be used are as follows:
as the steel material components, concentrations of at least C, Si, Mn, and Sb;
as the annealing conditions before the final cold rolling, at least a soaking temperature, a soaking time, and an oxygen potential P_{H2O}/P_{H2} of an atmospheric gas during soaking; and
as the decarburization annealing conditions, at least a decarburization temperature, a decarburization time, and an oxygen potential P_{H2O}/P_{H2} of an atmospheric gas during decarburization.

3. A method for creating a prediction model of an oxygen coating weight after decarburization annealing that is used when producing a grain-oriented electrical steel sheet by subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential),
**characterized in that**
the model that predicts the oxygen coating weight after decarburization annealing is created with at least three of steel material components, annealing conditions before final cold rolling, and decarburization annealing conditions set as explanatory variables, and a target variable corresponding to these explanatory variables set as the oxygen coating weight after decarburization annealing, wherein
the final cold rolling refers to cold rolling of rolling to a final sheet thickness, and the annealing before the final cold rolling refers to hot strip annealing when annealing performed in a step before the final cold rolling is only hot strip annealing, and to intermediate annealing when the annealing is only intermediate annealing or both of hot strip annealing and intermediate annealing.

4. The method for creating a prediction model of an oxygen coating weight according to claim 3, wherein the explanatory variables to be used are as follows:
as the steel material components, concentrations of at least C, Si, Mn, and Sb;
as the annealing conditions before the final cold rolling, at least a soaking temperature, a soaking time, and an oxygen potential P_{H2O}/P_{H2} of an atmospheric gas during soaking; and
as the decarburization annealing conditions, at least a decarburization temperature, a decarburization time, and an oxygen potential P_{H2O}/P_{H2} of an atmospheric gas during decarburization.

5. The method for creating a prediction model of an oxygen coating weight according to claim 3 or 4, wherein the creation of the prediction model of an oxygen coating weight is performed by multiple regression analysis or machine learning.

6. A production for producing a grain-oriented electrical steel sheet comprising a series of steps of subjecting a steel material for the grain-oriented electrical steel sheet to hot rolling, hot strip annealing as necessary, cold rolling once, or cold rolling twice or more with intermediate annealing in between, and decarburization annealing, applying an annealing separating agent containing MgO as a main agent to a steel sheet surface, and then performing finishing annealing (at least one annealing of the hot strip annealing and the intermediate annealing being essential),
**characterized in that**, using the prediction model of an oxygen coating weight according to claim 1 or 2, decarburization annealing conditions are set based on at least steel material components and annealing conditions before final cold rolling such that an oxygen coating weight after decarburization annealing meets a target value.
